# EUROPEAN PATENT SPECIFICATION

(11) **EP 1 647 980 B1**
(45) Date of publication and mention of the grant of the patent: **17.12.2008**
(21) Application number: 05256346.7
(22) Date of filing: 12.10.2005
(51) Int. Cl.: G11B 7/125, H01S 5/0683

(54) **Disk recording and reproducing apparatus**
Plattenaufnahme und -wiedergabegerät
Appareil d'enregistrement et de reproduction de disques

(30) Priority: 14.10.2004 KR 2004082032
(43) Date of publication of application: 19.04.2006
(73) Proprietor: Samsung Electronics Co., Ltd., Suwon-si, Gyeonggi-Do (KR)
(72) Inventor: Lee, Sang-hyun, Yeongtong-gu, Suwon-si Gyeonggi-do (KR)
(74) Representative: Robinson, Ian Michael

(56) References cited:
- US-A- 4 806 873
- US-A1- 2001 020 670
- US-A1- 2002 186 635

## Description

The present invention relates in general to an optical disk recording and reproducing apparatus, and more specifically, to an optical disk recording and reproducing apparatus with a minimum construction and a minimum size of a control board controlling optical output of a laser diode installed in the apparatus.

As a variety of optical disks are broadly used as storage media, a recent technical trend in optical pickup apparatuses is also to develop an apparatus capable of recording or reproducing information onto or from more than two optical disks in consideration of compatibility between optical disks. For examples, a DVD-ROM reproducing apparatus currently released in the market is capable of reproducing an existing CD, and a combo drive is now capable of reproducing and/or recording a CD, and reproducing a DVD. In the past, the optical disk recording and/or reproducing apparatus had a separate built-in laser diode corresponding to each recording medium (e.g., a CD or a DVD). But technical advances introduced a laser source that can generate a plurality of wavelengths.

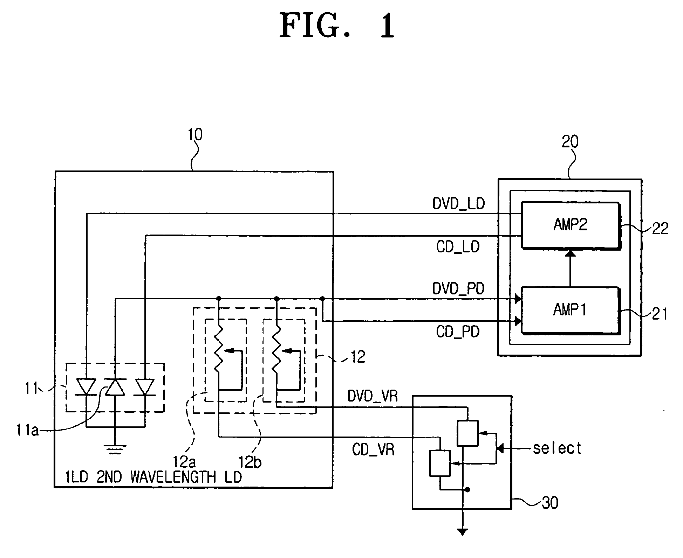

Figure 1 is a block diagram of an ALPC (Automatic Laser Power Control) unit included in a conventional optical disk recording and reproducing apparatus. As can be seen in Figure 1, the ALPC circuit includes a current controller 30 to select an output current of a photo diode 11a output from a pickup 10 by a recording medium selection signal; a first AMP 21 to compare a voltage across the selected current by the current controller 30 to a reference voltage (not shown); and a second AMP 22 to provide a current to a laser source part 11 based on a result of the comparison of the first AMP. In this traditional ALPC circuit, a pick up drive unit 20 and the current controller 30 had to be mounted on one single board, system on chip (SoC), so the size of the board was usually large. Also, the board used at least 6 wires for connection with a pickup 10 showing a reciprocal (or to-and-fro) movement on the optical disk.

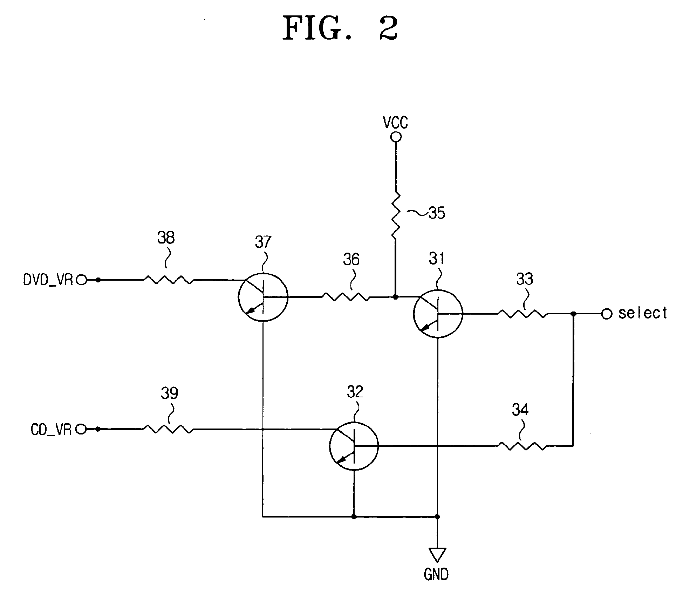

Figure 2 illustrates an internal circuit diagram of the current controller 30 in Figure 1.

In the current controller, one of variable resistances 12a and 12b provided to the pickup 10 by a transistor 31, turned on/off by a recording medium selection signal, forms a current path with a ground terminal.

Referring to Figure 2, when the recording medium selection signal is logic "low", the transistor 31 is turned off, and source voltage VCC passes through resistances 35 and 36 and is applied to a base terminal of the transistor 37. Then, the transistor 37 is turned on, and a current path having a predetermined resistance (a resultant resistance of resistance 38 and an internal resistance of the transistor 37) is formed between a terminal DVD_VR and the ground terminal. Here, the collector terminal of the transistor 32 enters a high-impedance state. In contrast, when the recording medium selection signal is logic "high", the transistor 31 is turned on and source voltage VCC is discharged to the ground terminal, so that the transistor 37 is turned off. At this time, the transistor 32 is turned on, and conducts a terminal CD_VR and a ground terminal. That is, in the pickup drive unit 20, a current applied to the first AMP 21, in response to the recording medium selection signal, varies, and the first AMP 21 controls an optical power output of the laser diode 11 based on the comparison of a reference voltage to a voltage corresponding to the applied current. In the case of the traditional ALPC circuit, the current controller composed of at least three transistors and six resistances and the pickup drive unit were arranged on the same circuit board, and connected to the pickup 10 moving to and fro to read and/or write an optical disk through at least 6 wires. This not only increased the size of the board, but also caused wire separation and contact failure. In addition, a processor (not shown) provided to control the optical disk recording and/or reproducing apparatus must allocate a separate port to apply the recording medium selection signal to the current controller 30. In so doing, the processor is often deprived of its operable input/output ports to the current controller 30.

US 2001/0020670A discloses an automatic power control circuit in which parallel connected variable resistors are connected in series to a monitor diode for detecting an emission intensity of light emitting elements. Voltages generated at moveable contacts of the variable resistors are supplied to input terminals of a pair of differential amplifiers, while reference voltages are applied to other input terminals of the differential amplifiers. A switching element selectively connects one of the variable resistances to a ground terminal. This document forms the pre-characterising portion of the claims appended hereto.

US 4,806,873 discloses a laser diode driving circuit in which a photo diode monitors the light output by a laser diode and generates a photovoltaic current that corresponds to the level of the light output. A reference current selection device selects a required reference current by switching among a plurality of reference currents. An amplifying apparatus receives a signal that corresponds to the photovoltaic current and controls a forward current of a laser diode so as to bring the photovoltaic current to the selected reference current.

US 2002/0186635A discloses an optical pickup which includes two laser diodes having different wavelengths, a photo-detector for detecting the laser power of each of the laser diodes and two adjusters for adjusting a detection signal of the photo-detector according to the level of laser power.

According to the present invention there is provided an apparatus and method as set forth in the appended claims. Preferred features of the invention will be apparent from the dependent claims, and the description which follows.

An aspect of the present invention provides an optical disk recording and reproducing apparatus having a minimal construction and a minimal size of an ALPC circuit, using a least number of input/output ports of a processor.

Another aspect of the present invention provides an optical disk recording and reproducing apparatus using a minimum number of wires for connecting a pickup and a board installed therein, thereby increasing durability of the apparatus.

One embodiment of the present invention provides a recording and/or reproducing apparatus for recording/reproducing information to/from a medium using a laser source generating light beams of different wavelengths, the apparatus comprising: a pickup part comprising the laser source, a photo diode to detect an optical output power of the laser source; the pickup part comprising a current variation unit to vary an output current of the photo diode based on a medium type of the medium; and a pickup drive unit comprising a current controller to selectively output one of a plurality of current values simultaneously conducting between an output terminal of the photo diode and a ground terminal according to a recording medium selection signal, based on the medium type of the medium, and an amplifier to provide a driving current to drive the laser source, the driving current being obtained based on a difference between the selectively output current value and a reference current value selected according to the recording medium selection signal.

Another embodiment of the present invention provides a method of recording/reproducing information to/from a medium using a laser source generating light beams of different wavelengths, the method comprising: detecting an optical output power of the laser source through a photo diode; varying an output current of the photo diode based on a medium type of the medium; selectively outputting one of a plurality of current values simultaneously conducting between an output terminal of the photo diode and a ground terminal according to a recording medium selection signal, based on the medium type of the medium; and amplifying the selectively output current value to provide a driving current to drive the laser source, the driving current being obtained based on a difference between the selected current value and a reference current value selected according to the recording medium selection signal.

Additional aspects and/or advantages of the invention will be set forth in part in the description which follows and, in part, will be apparent from the description, or may be learned by practice of the invention.

These and/or other aspects and advantages of the invention will become apparent and more readily appreciated from the following description of the embodiments, taken in conjunction with the accompanying drawings of which:
Figure 1 is a conceptual block diagram of an ALPC (Automatic Laser Power Control) unit in a conventional optical disk recording and/or reproducing apparatus;
Figure 2 illustrates an internal circuit diagram of the current controller in Figure 1;
Figure 3 is a block diagram of an ALPC circuit built in an optical disk recording and/or reproducing apparatus, according to an embodiment of the present invention;
Figure 4 is a detailed block diagram of a first AMP, such as the first AMP in Figure 3, according to an embodiment of the present invention; and
Figure 5 illustrates a wire connection between a pickup and a pickup drive unit in an optical disk recording and/or reproducing apparatus with an ALPC circuit, according to an embodiment of the present invention.

Reference will now be made in detail to embodiments of the present invention, examples of which are illustrated in the accompanying drawings, wherein like reference numerals refer to the like elements throughout. Embodiments are described below to explain the present invention by referring to the figures.

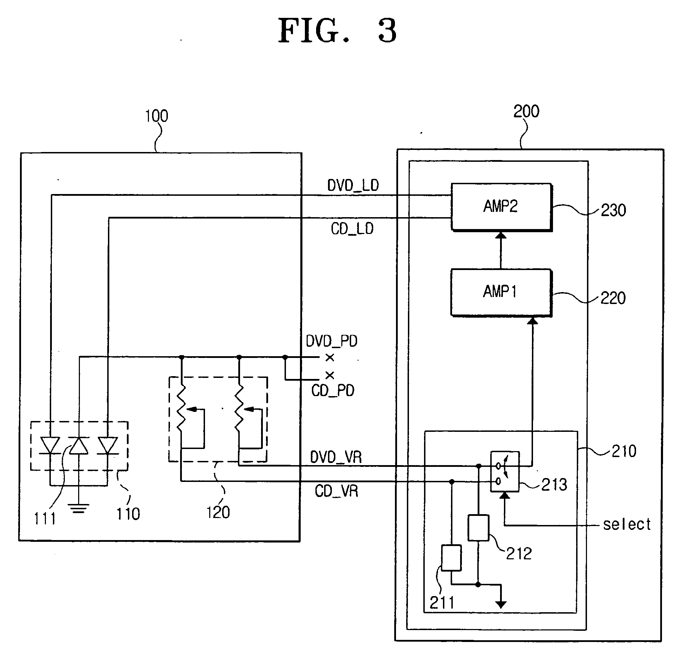

Figure 3 is a block diagram of an ALPC circuit built in an optical disk recording and/or reproducing apparatus, according to an aspect of the present invention.

As shown in Figure 3, the ALPC circuit may include a pickup unit 100, and a pickup drive unit 200 which increases or decreases current flow applied to a laser diode unit 110 of the pickup unit 100, according to an output current thereof, and thus, control the output of the laser diode unit 110. The pickup unit 100 may include a laser diode unit 110 having a variable wavelength according to a kind of an optical disk such as a CD and a DVD; a photo diode 111 in the laser diode unit 110, to detect an output of the laser diode 110; and a current variation unit 120 connected to input/output ports DVD_VR and CD_VR provided by the pickup drive unit 200, to vary an output current of the photo diode 111.

The pickup drive unit 200 may include a current controller 210 to form a current path between one of input/output ports DVD_VR and CD_VR provided to the pickup unit 100 and the ground terminal by a medium selection signal; a first AMP 220 to compare a voltage across the output value of the current controller 210 with a reference voltage, and to calculate a difference thereof; and a second AMP 230 to generate a driving current to drive the laser diode 110 based on the difference, and to provide the current to a laser diode 110.

Here, the recording medium selection signal may be generated by a micro controller (not shown) built in the optical disk recording and/or reproducing apparatus, and provided to the pickup drive unit 200. Based on the type of medium, i.e., the "type" corresponding to whether the medium meets certain different medium specifications (e.g., a CD specification or a DVD specification), inserted into the optical disk recording and/or reproducing apparatus, the recording medium selection signal is logic "high" or logic "low".

In response to the recording medium selection signal, the current controller 210 can form a current path between one of the input/output ports DVD_VR and CD_VR, provided to the current variation unit 120, and the ground terminal. Resistances 211 and 212 of the current controller 210 may have predetermined values. Although Figure 3 shows only two resistances 211 and 212 conducting between the input/output ports DVD_VR and CD_VR and the current controller 210, more resistances may be added, and the additional resistances can be applied to the first AMP 220 by the medium selection signal. In such case, the recording medium selection signal may be formed of at least 2 bits. For instance, the recording medium selection signal may be "00", "01", "10" and "11" or "000", "001", "010", "011", "100", "101", "110" and "111", and enable the current controller 210 to form diverse routes for the current flow between the input/output ports DVD_VR and CD_VR and the ground terminal. When the recording medium selection signal is formed of at least 2 bits, a plurality of built-in resistances (at least two) in an array may further be used, so that the pickup drive unit 200 can selectively use any desired resistance.

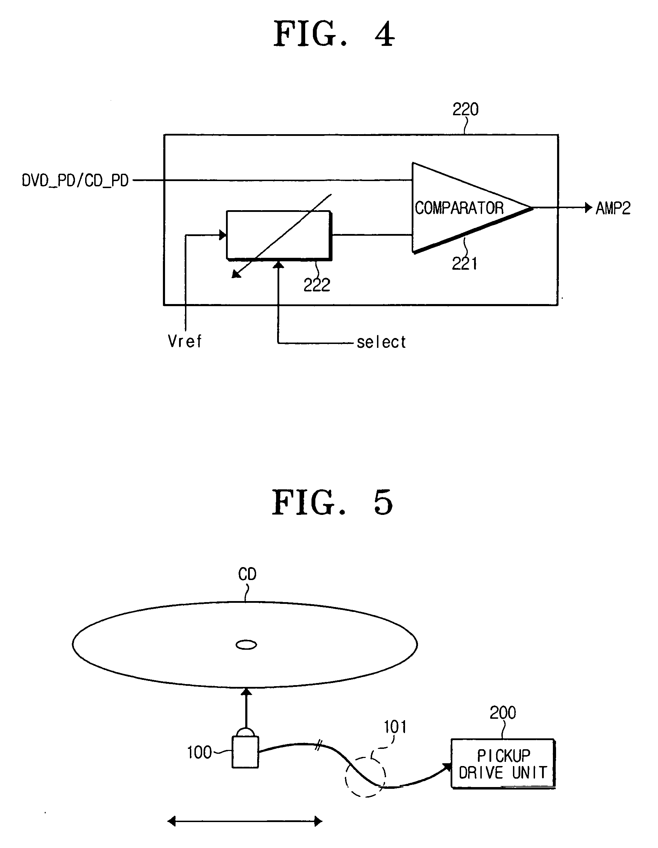

The first AMP 220 may receive an output current from the current controller 210 and obtain a voltage value for the current of the first AMP 220. Then, the first AMP 220 can compare the voltage value with a reference voltage that is generated by dividing a predetermined voltage with the recording medium selection signal. This operation will be explained in greater detail in reference to Figure 4. Figure 4 is a detailed block diagram of a first AMP, such as the first AMP in Figure 3, according to an embodiment of the present invention.

As shown in Figure 4, the first AMP 220 may include a comparator 221 to compare a voltage value DVD_PD, CD_PD (i.e., a main input) for an output current from the current controller 210 with an output voltage (i.e., a sub input) from a reference voltage generator 222 (to be further described below); and a reference voltage generator 222 to divide a predetermined voltage Vref by the recording medium selection signal, and generate a reference voltage by the type of optical disk inserted into the optical disk recording and/or reproducing apparatus. Since optical outputs and wavelengths of the laser diode 110 differ depending on the type of recording medium used in the optical disk recording and/or reproducing apparatus, the reference voltage generator 222 may generate different reference voltages depending on recording medium inserted into the optical disk recording and/or reproducing apparatus. Here, since the reference voltages for different types of media may differ according to individual vender specifications for their respective recording and/or reproducing apparatuses, it will not be necessary to discuss specific values of the reference voltages herein. An output from the first AMP 220 may have an analog voltage value, and this value can equal a difference between the applied voltage DVD_PD, CD_PD, to the comparator 221, and a reference voltage applied from the reference voltage generator 222, to the comparator 221. The second AMP 230 may decide an output value of the laser diode 110 based on the output value of the first AMP 220, and either increase or decrease an applied current value to the laser diode 110 according to a result of the decision. If an output value of the first AMP 220 has a positive value, for example, it may mean that the applied voltage value DVD_PD, CD_PD to the first AMP 220 is greater than the reference voltage applied from the reference voltage generator 222 to the comparator 221. In this case, the second AMP 230 may decrease the applied current to the laser diode 110, and if the value is not positive, the second AMP 230 may increase the applied current to the laser diode 110.

Figure 5 illustrates a wire connection between the pickup 100 and the pickup drive unit 200 in an optical disk recording and reproducing apparatus to which the ALPC circuit of the present invention may be applied.

Referring to Figure 5, the pickup 100 and the pickup drive unit 200 can be connected through four strands of wire 101. As illustrated, the pickup 100 may move from side to side of the optical disk, and the wire 101 connected to the pickup 100 can repeatedly expand and contract (i.e., stretch) along with the movement of the pickup 100. Since four strands of wire 101, rather than six strands of wire as in the conventional systems, are used, the occurrence of metal fatigue to the wire during the stretching is greatly reduced, with the lifespan of the wire correspondingly being increased. Moreover, although the conventional optical disk recording and reproducing apparatus required a separate board for the installation of the pickup drive unit and the current controller, the system-on-chip of the present invention can be installed on the optical disk recording and reproducing apparatus without using a separate board. This is made possible by integrating the current controller 210 into the system-on-chip, and reducing the number of strands of wire connected to the pickup 100. As a result, not only has the size of the optical disk recording and reproducing apparatus been reduced, but the cost of manufacture thereof has also been markedly reduced.

As explained above, according to embodiments of the present invention, the size of the ALPC circuit board provided to the optical disk recording and reproducing apparatus can be minimized, and in some cases, it is also possible to attach the system-on-chip of the ALPC circuit to a frame for the optical disk recording and reproducing apparatus. In either case, the size of the optical disk recording and reproducing apparatus can be minimized.

Furthermore, by integrating the current controller of the ALPC circuit into the system-on-chip and by providing the current controller with the recording medium selection signal based on the type of medium inserted into the optical disk recording and reproducing apparatus, it becomes possible to minimize the usage count of the input/output ports of the processor installed in the optical disk recording and reproducing apparatus.

Also, by minimizing the number of strands of wire connected between the pickup and the pickup drive unit, damage to the wire (e.g., metal fatigue), due to the repetitive stretching of the pickup, can be minimized.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s).

## Claims

1. A recording and/or reproducing apparatus for recording/reproducing information to/from a medium using a laser source (110) generating light beams of different wavelengths, the apparatus comprising:
a pickup part (100) comprising the laser source (110), a photo diode (111) to detect an optical output power of the laser source (110);
the pickup part (100) comprising a current variation unit (120) to vary an output current of the photo diode (111) based on a medium type of the medium; and
a pickup drive unit (200) comprising a current controller (210) to selectively output one of a plurality of current values conducting between an output terminal of the photo diode (111) and a ground terminal according to a recording medium selection signal, based on the medium type of the medium, and an amplifier (220, 230) to provide a driving current to drive the laser source (110), the driving current being obtained based on a difference between the selectively output current value and a reference current value selected according to the recording medium selection signal, **characterized in that** said plurality of current values are simultaneously conducting between said output terminal of said photo diode (111) and said ground terminal.

2. The apparatus of claim 1, wherein the pickup drive unit (200) comprises:
the current controller (210) arranged to generate a current value corresponding to one of a plurality of output currents from the current variation unit (120) according to the recording medium selection signal;
a first amplifier (220) to compare the current value selectively output from the current controller (210), according to the recording medium selection signal, to the reference current value, and to calculate a difference between the current value and the reference current value; and
a second amplifier (230) to generate a driving current to drive the laser source (110) based on the difference obtained by the first amplifier (220), and to provide the driving current to the laser source (110).

3. The apparatus of claim 2, wherein the output value of the first amplifier (220) is an analog voltage value.

4. The apparatus of claim 2, wherein the current controller (210) comprises:
a current variation unit (211, 212) to form a current path between output currents from the current variation unit (120) of the pickup part (100) and the ground terminal, wherein each current path has a predetermined resistance value; and
a switching unit (213) to select one of the plurality of currents output from the current variation unit (211, 212) according to the recording medium selection signal.

5. The apparatus of claim 4, wherein the current variation unit (211, 212) of the current controller (210) comprises a plurality of resistances arranged in an array between the plurality of currents output from the current variation unit (120) of the pickup part, according to the recording medium selection signal and, the ground terminal.

6. The apparatus of any of claims 2 to 5, wherein the first amplifier (220) comprises:
a reference voltage generator (222) to generate the reference voltage corresponding to the recording medium selection signal; and
a comparer (221) to compare an output value from the reference voltage generator (222) to the output value from the current controller (210).

7. The apparatus of claim 6, wherein the reference voltage generator (222) divides a predetermined reference voltage in response to the recording medium selection signal.

8. The apparatus of any preceding claim, wherein the pickup drive unit (200) is disposed on one side of a frame forming the recording and reproducing apparatus, and does not require a separate printed circuit board.

9. The apparatus of any preceding claim, wherein the pickup drive unit (200) is disposed on a system-on-chip.

10. The apparatus of any preceding claim, wherein the medium type is any one of DVD (Digital versatile Disk) medium type or CD (Compact Disk) medium type.

11. The apparatus of any preceding claim, wherein the recording medium selection signal comprises at least 2 bits.

12. A method of recording/reproducing information to/from a medium using a laser source (110) generating light beams of different wavelengths, the method comprising:
detecting an optical output power of the laser source (110) through a photo diode (111);
varying an output current of the photo diode (111) based on a medium type of the medium;
selectively outputting one of a plurality of current values conducting between an output terminal of the photo diode (111), and a ground terminal according to a recording medium selection signal, based on the medium type of the medium; and
amplifying the selectively output current value to provides a driving current to drive the laser source (110), the driving current being obtained based on a difference between the selected current value and a reference current value selected according to the recording medium selection signal,
**characterized in that** said plurality of current values are simultaneously conducting between said output terminal of said photo diode (111) and said ground terminals.

13. The method of claim 12, further comprising:
generating the current value as corresponding to one of a plurality of output currents from a current variation unit (211, 212) according to the recording medium selection signal;
comparing an output current value output from a current controller (210), according to the recording medium selection signal, to the reference current value;
generating the driving current to drive the laser source (110) based on a calculated difference between the output current value and the reference current value.

## Patentansprüche

1. Aufzeichnungs- und/oder Wiedergabevorrichtung zum Aufzeichnen/Wiedergeben von Informationen auf/aus einem Medium unter Verwendung einer Laserquelle (110), die Lichtstrahlen verschiedener Wellenlängen erzeugt, wobei die Vorrichtung folgendes umfaßt:
einen Pickup-Teil (100) mit der Laserquelle (110), einer Fotodiode (111) zum Detektieren einer optischen Ausgangsleistung der Laserquelle (110);
wobei der Pickup-Teil (100) eine Stromvariationseinheit (120) zum Variieren eines Ausgangsstroms der Fotodiode (111) auf der Basis eines Mediumtyps des Mediums umfaßt; und
eine Pickup-Ansteuereinheit (200) mit einer Stromsteuerung (210) zum selektiven Ausgeben eines von mehreren Stromwerten, die zwischen einem Ausgangsanschluß der Fotodiode (111) und einem Masseanschluß fließen, gemäß einem Aufzeichnungsmedium-Auswahlsignal auf der Basis des Mediumtyps des Mediums und einem Verstärker (220, 230) zum Bereitstellen eines Ansteuerstroms zum Ansteuern der Laserquelle (110), wobei der Ansteuerstrom auf der Basis einer Differenz zwischen dem selektiv ausgegebenen Stromwert und einem gemäß dem Aufzeichnungsmedium-Auswahlsignal ausgewählten Referenzstromwert erhalten wird, **dadurch gekennzeichnet, daß** die mehreren Stromwerte gleichzeitig zwischen dem Ausgangsanschluß der Fotodiode (111) und dem Masseanschluß fließen.

2. Vorrichtung nach Anspruch 1, wobei die Pickup-Ansteuereinheit (200) folgendes umfaßt:
die Stromsteuerung (210), die dafür ausgelegt ist, gemäß dem Aufzeichnungsmedium-Auswahlsignal einen Stromwert zu erzeugen, der einem von mehreren Ausgangsströmen der Stromvariationseinheit (120) entspricht;
einen ersten Verstärker (220) zum Vergleichen des selektiv gemäß dem Aufzeichnungsmedium-Auswahlsignal von der Stromsteuerung (210) ausgegebenen Stromwerts mit dem Referenzstromwert und zum Berechnen einer Differenz zwischen dem Stromwert und dem Referenzstromwert; und
einen zweiten Verstärker (230) zum Erzeugen eines Ansteuerstroms zum Ansteuern der Laserquelle (110) auf der Basis der durch den ersten Verstärker (220) erhaltenen Differenz und zum Zuführen des Ansteuerstroms zu der Laserquelle (110).

3. Vorrichtung nach Anspruch 2, wobei der Ausgangswert des ersten Verstärkers (220) ein analoger Spannungswert ist.

4. Vorrichtung nach Anspruch 2, wobei die Stromsteuerung (210) folgendes umfaßt:
eine Stromvariationseinheit (211, 212) zum Bilden eines Strompfads zwischen Ausgangsströmen der Stromvariationseinheit (120) des Pickup-Teils (100) und dem Masseanschluß, wobei jeder Strompfad einen vorbestimmten Widerstandswert aufweist; und
eine Schalteinheit (213) zum Auswählen eines der mehreren von der Stromvariationseinheit (211, 212) ausgegebenen Ströme gemäß dem Aufzeichnungsmedium-Auswahlsignal.

5. Vorrichtung nach Anspruch 4, wobei die Stromvariationseinheit (211, 212) der Stromsteuerung (210) mehrere Widerstandswerte umfaßt, die gemäß dem Aufzeichnungsmedium-Auswahlsignal in einem Array zwischen den mehreren von der Stromvariationseinheit (120) des Pickup-Teils ausgegebenen Strömen und dem Masseanschluß angeordnet sind.

6. Vorrichtung nach einem der Ansprüche 2 bis 5, wobei der erste Verstärker (220) folgendes umfaßt:
einen Referenzspannungsgenerator (222) zum Erzeugen der Referenzspannung entsprechend dem Aufzeichnungsmedium-Auswahlsignal; und
einen Vergleicher (221) zum Vergleichen eines Ausgangswerts des Referenzspannungsgenerators (222) mit dem Ausgangswert der Stromsteuerung (210).

7. Vorrichtung nach Anspruch 6, wobei der Referenzspannungsgenerator (222) eine vorbestimmte Referenzspannung als Reaktion auf das Aufzeichnungsmedium-Auswahlsignal teilt.

8. Vorrichtung nach einem der vorhergehenden Ansprüche, wobei die Pickup-Ansteuereinheit (200) auf einer Seite eines die Aufzeichnungs- und Wiedergabevorrichtung bildenden Gestells angeordnet ist und keine separate Leiterplatte benötigt.

9. Vorrichtung nach einem der vorhergehenden Ansprüche, wobei die Pickup-Ansteuereinheit (200) auf einem System-auf-Chip angeordnet ist.

10. Vorrichtung nach einem der vorhergehenden Ansprüche, wobei der Mediumtyp ein beliebiger der folgenden ist: DVD (Digital Versatile Disk) oder CD (Compact Disk).

11. Vorrichtung nach einem der vorhergehenden Ansprüche, wobei das Aufzeichnungsmedium-Auswahlsignal mindestens 2 Bit umfaßt.

12. Verfahren zum Aufzeichnen/Wiedergeben von Informationen auf/aus einem Medium unter Verwendung einer Laserquelle (110), die Lichtstrahlen verschiedener Wellenlängen erzeugt, wobei das Verfahren folgendes umfaßt:
Detektieren einer optischen Ausgangsleistung der Laserquelle (110) durch eine Fotodiode (111);
Variieren eines Ausgangsstroms der Fotodiode (111) auf der Basis eines Mediumtyps des Mediums;
selektives Ausgeben eines von mehreren Stromwerten, die zwischen einem Ausgangsanschluß der Fotodiode (111) und einem Masseanschluß fließen, gemäß einem Aufzeichnungsmedium-Auswahlsignal auf der Basis des Mediumtyps des Mediums; und
Verstärken des selektiv ausgegebenen Stromwerts, um einen Ansteuerstrom zum Ansteuern der Laserquelle (110) bereitzustellen, wobei der Ansteuerstrom auf der Basis einer Differenz zwischen dem selektiven ausgegebenen Stromwert und einem gemäß dem Aufzeichnungsmedium-Auswahlsignal ausgewählten Referenzstromwert erhalten wird, **dadurch gekennzeichnet, daß** die mehreren Stromwerte gleichzeitig zwischen dem Ausgangsanschluß der Fotodiode (111) und dem Masseanschluß fließen.

13. Verfahren nach Anspruch 12, ferner umfassend:
Erzeugen des Stromwerts als einem von mehreren Ausgangsströmen einer Stromvariationseinheit (211, 212) entsprechend gemäß dem Aufzeichnungsmedium-Auswahlsignal;
Vergleichen eines von einer Stromsteuerung (210) gemäß dem Aufzeichnungsmedium-Auswahlsignal ausgegebenen Ausgangsstromwerts mit dem Referenzstromwert;
Erzeugen des Ansteuerstroms zum Ansteuern der Laserquelle (110) auf der Basis einer berechneten Differenz zwischen dem Ausgangsstromwert und dem Referenzstromwert.

## Revendications

1. Appareil d'enregistrement et/ou de reproduction d'informations d'enregistrement/reproduction sur/depuis un support au moyen d'une source laser (110) générant des faisceaux de lumière de différentes longueurs d'onde, l'appareil comprenant:
une pièce de lecture (100) comprenant la source laser (110), une photodiode (111) afin de détecter une puissance de sortie optique de la source laser (110);
la pièce de lecture (100) comprenant un module de variation de courant (120) pour faire varier un courant de sortie de la photodiode (111) en fonction d'un type de support du support ; et
un module d'attaque de lecture (200) comprenant une unité de commande de courant (210) afin de produire sélectivement en sortie l'une d'une pluralité de valeurs de courant conduisant entre une borne de sortie de la photodiode (111) et une borne de masse conformément à un signal de sélection de support d'enregistrement, en fonction du type de support du support, et un amplificateur (220, 230) pour fournir un courant d'attaque afin d'attaquer la source laser (110), le courant d'attaque étant obtenu en fonction d'une différence entre la valeur de courant sortie sélectivement et une valeur de courant de référence sélectionnée conformément au signal de sélection de support d'enregistrement, **caractérisé en ce que** les valeurs de courant de ladite pluralité de valeurs de courant conduisent simultanément entre ladite borne de sortie de ladite photodiode (111) et ladite borne de masse.

2. Appareil selon la revendication 1, dans lequel le module d'attaque de lecture (200) comprend :
l'unité de commande de courant (210) agencée afin de générer une valeur de courant correspondant à l'un d'une pluralité de courants de sortie provenant du module de variation de courant (120) conformément au signal de sélection de support d'enregistrement ;
un premier amplificateur (220) afin de comparer la valeur de courant sortie sélectivement par l'unité de commande de courant (210), conformément au signal de sélection de support d'enregistrement, à la valeur de courant de référence, et calculer une différence entre la valeur de courant et la valeur de courant de référence ; et
un second amplificateur (230) afin de générer un courant d'attaque afin d'attaquer la source laser (110) en fonction de la différence obtenue par le premier amplificateur (220), et fournir le courant d'attaque à la source laser (110).

3. Appareil selon la revendication 2, dans lequel la valeur de sortie du premier amplificateur (220) est une valeur de tension analogique.

4. Appareil selon la revendication 2, dans lequel l'unité de commande de courant (210) comprend :
un module de variation de courant (211, 212) afin de former un chemin de courant entre des courants de sortie provenant du module de variation de courant (120) de la pièce de lecture (100) et la borne de masse, dans lequel chaque chemin de courant a une valeur de résistance prédéterminée ; et
un module de commutation (213) afin de sélectionner l'un de la pluralité de courants sortis par le module de variation de courant (211, 212) conformément au signal de sélection de support d'enregistrement.

5. Appareil selon la revendication 4, dans lequel le module de variation de courant (211, 212) de l'unité de commande de courant (210) comprend une pluralité de résistances agencées en réseau entre la pluralité de courants produits par le module de variation de courant (120) de la pièce de lecture, conformément au signal de sélection de support d'enregistrement et la borne de masse.

6. Appareil selon l'une quelconque des revendications 2 à 5, dans lequel le premier amplificateur (220) comprend :
un générateur de tension de référence (222) pour générer la tension de référence correspondant au signal de sélection de support d'enregistrement ; et
un comparateur (221) pour comparer une valeur de sortie provenant du générateur de tension de référence (222) à la valeur de sortie provenant de l'unité de commande de courant (210).

7. Appareil selon la revendication 6, dans lequel le générateur de tension de référence (222) divise une tension de référence prédéterminée en réponse au signal de sélection de support d'enregistrement.

8. Appareil selon l'une quelconque des revendications précédentes, dans lequel le module d'attaque de lecture (200) est disposé sur un côté d'un cadre formant l'appareil d'enregistrement et de reproduction, et n'exige pas de carte de circuit imprimé séparée.

9. Appareil selon l'une quelconque des revendications précédentes, dans lequel le module d'attaque de lecture (200) est disposé sur un système sur puce.

10. Appareil selon l'une quelconque des revendications précédentes, dans lequel le type de support est n'importe lequel d'un type de support DVD (Disque numérique polyvalent) ou d'un type de support CD (Disque compact).

11. Appareil selon l'une quelconque des revendications précédentes, dans lequel le signal de sélection de support d'enregistrement comprend au moins 2 bits.

12. Procédé d'enregistrement/reproduction d'informations sur/depuis un support au moyen d'une source laser (110) générant des faisceaux de lumière de différentes longueurs d'onde, le procédé comprenant:
la détection d'une puissance de sortie optique de la source laser (110) par le biais d'une photodiode (111) ;
la variation d'un courant de sortie de la photodiode (111) en fonction d'un type de support du support ;
la production sélective en sortie de l'une d'une pluralité de valeurs de courant conduisant entre une borne de sortie de la photodiode (111) et une borne de masse conformément à un signal de sélection de support d'enregistrement, en fonction du type de support du support ; et
l'amplification de la valeur de courant sortie sélectivement afin de fournir un courant d'attaque pour attaquer la source laser (110), le courant d'attaque étant obtenu en fonction d'une différence entre la valeur de courant sortie sélectivement et une valeur de courant de référence sélectionnée conformément au signal de sélection de support d'enregistrement, **caractérisé en ce que** les valeurs de courant de ladite pluralité de valeurs de courant conduisent sélectivement entre ladite borne de sortie de ladite photodiode (111) et ladite borne de masse.

13. Procédé selon la revendication 12, comprenant en outre :
la génération de la valeur de courant comme correspondant à l'un d'une pluralité de courants de sortie provenant d'un module de variation de courant (211, 212) conformément au signal de sélection de support d'enregistrement ;
la comparaison d'une valeur de courant de sortie produite en sortie par une unité de commande de courant (210), conformément au signal de sélection de support d'enregistrement, à la valeur de courant de référence ;
la génération du courant d'attaque afin d'attaquer la source laser (110) en fonction d'une différence calculée entre la valeur de courant sortie et la valeur de courant de référence.
